(19) Europäisches Patentamt / European Patent Office / Office européen des brevets

(11) **EP 2 816 363 B1**

(12) **FASCICULE DE BREVET EUROPEEN**

(45) Date de publication et mention
de la délivrance du brevet:
**28.11.2018 Bulletin 2018/48**

(51) Int Cl.:
*G01R 31/02* *(2006.01)*     *G01R 31/12* *(2006.01)*
*H02H 1/00* *(2006.01)*

(21) Numéro de dépôt: **14173288.3**

(22) Date de dépôt: **20.06.2014**

(54) **Procédé et dispositif de détection d'arc électrique**

Verfahren und Vorrichtung zur Detektion eines Lichtbogens

Method and device for detecting an electric arc

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.06.2013 FR 1355914**

(43) Date de publication de la demande:
**24.12.2014 Bulletin 2014/52**

(73) Titulaire: **Schneider Electric Industries SAS
92500 Rueil-Malmaison (FR)**

(72) Inventeurs:
• **Belhaja, Zakaria
38050 GRENOBLE CEDEX 09 (FR)**
• **Tian, Simon
38050 GRENOBLE Cedex 09 (FR)**
• **Zeller, Clément
38050 GRENOBLE CEDEX 09 (FR)**

(74) Mandataire: **Lavoix
62, rue de Bonnel
69448 Lyon Cedex 03 (FR)**

(56) Documents cités:
GB-A- 2 348 751     US-A- 5 561 605
US-A- 5 602 709     US-A1- 2003 227 290
US-A1- 2009 161 270     US-B2- 7 345 860

• VEEN J ET AL: "The application of matched filters
to pd detection and localization", IEEE
ELECTRICAL INSULATION MAGAZINE, IEEE
SERVICE CENTER, NEW YORK, NY, US, vol. 19,
no. 5, 1 septembre 2003 (2003-09-01), pages
20-26, XP011102584, ISSN: 0883-7554, DOI:
10.1109/MEI.2003.1238714

**Description**

La présente invention concerne la détection d'arc électrique dans une installation électrique par calcul de corrélation appliquée à des échantillons fréquentiels. Une telle détection permet de stopper la circulation de courant électrique si nécessaire afin d'éviter que l'installation électrique ne soit endommagée.
Plus précisément, la présente invention est relative à un procédé de détection d'arc électrique dans une installation électrique fournissant un signal électrique, comprenant les étapes suivantes réalisées relativement à une fenêtre courante d'une pluralité de fenêtres temporelles d'observation du signal électrique :

> i/ application audit signal électrique en parallèle d'au moins un premier filtrage centré sur une première fréquence, d'un deuxième filtrage centré sur une deuxième fréquence et d'un troisième filtrage centré sur une troisième fréquence, lesdites première, deuxième et troisième fréquences étant distinctes ;
> ii/ détermination, pour ladite fenêtre, d'au moins d'échantillons issus du premier filtrage, d'échantillons issus du deuxième filtrage et d'échantillons issus du troisième filtrage ;
> iii/ détermination de la corrélation entre lesdits échantillons déterminés pour la fenêtre courante et des échantillons déterminés suite à la mise en oeuvre des étapes i/ et /ii pour au moins une autre fenêtre de la pluralité de fenêtres temporelles d'observation du signal électrique ; et
> iv/ détection de la présence d'un arc électrique en fonction d'au moins ladite corrélation déterminée ;

Certaines techniques, par exemple celle exposée dans le document US 7, 345, 860, détectent un arc en mettant en oeuvre une étape de reconnaissance du type de charges présentes sur l'installation électrique, à partir des signaux résultant du filtrage du signal électrique par trois filtres passe-bandes disposés en parallèle.
D'autres techniques évitent cette étape de reconnaissance de charge en se basant sur les réponses des trois filtres. Une difficulté est liée à la présence d'un bruit généré par certaines charges comme les gradateurs de lumière.
L'application d'un calcul de corrélation permet de détecter l'aspect aléatoire de ce bruit et de limiter les fausses détections d'arc électrique dues à un tel bruit. Un signal sommant les sorties des trois filtres sur une durée d'un cycle d'observation est déterminé sous réserve que la sortie de chacun des filtres soit strictement positive, et la corrélation entre ce signal et le signal correspondant à un autre cycle est calculée. Ainsi une corrélation, supérieure à un seuil donné, et obtenue pour des valeurs strictement positives en sortie de chacun des filtres, peut être un signe de la présence d'un arc.
US 5 602 709 A décrit un procédé et un appareil pour détecter des fautes de haute impédance et d'autres phénomènes d'arc dans un système de distribution électrique.
US 5 561 605 A décrit une technique de détection d'arc utilisant une variation du courant alternatif de ligne.
US 2003/227290 A1 décrit une technique de détection d'arc basé sur une corrélation de signaux non-causaux.
La présente invention vise à améliorer la détection d'arc électrique.
A cet effet, suivant un premier aspect, l'invention propose un procédé de détection d'arc électrique du type précité caractérisé en ce que l'étape iii/ de détermination de la corrélation comprend la détermination d'au moins une corrélation respective parmi :

- une première corrélation entre lesdits échantillons issus du premier filtrage et déterminés pour la fenêtre courante et des échantillons issus du premier filtrage et déterminés pour l'autre fenêtre ;
- une deuxième corrélation entre lesdits échantillons issus du deuxième filtrage et déterminés pour la fenêtre courante et des échantillons issus du deuxième filtrage et déterminés pour l'autre fenêtre;
- une troisième corrélation entre lesdits échantillons issus du troisième filtrage et déterminés pour la fenêtre courante et des échantillons issus du troisième filtrage et déterminés pour l'autre fenêtre ; et

en ce que l'étape iv/ de détection de la présence d'un arc est fonction d'au moins la corrélation déterminée parmi ladite première, deuxième et troisième corrélations.
L'invention permet ainsi de prendre en compte la corrélation du signal en sortie de chaque filtre indépendamment et de détecter la présence d'un arc sur cette base. Cette disposition permet de réduire le risque de fausser la détection d'arc par rapport à une technique de détection basée sur une corrélation déterminée sur la somme des signaux fournis par les trois filtres.
En outre, la corrélation n'était calculée que lorsque les échantillons étaient strictement supérieurs à zéro en sortie de chacun des trois filtres. Or il existe des signatures d'arcs selon lesquelles il n'y a qu'une ou deux réponses fournie(s) par l'ensemble des trois filtres.
Dans des modes de réalisation, le procédé suivant l'invention comporte en outre une ou plusieurs des caractéristiques suivantes :

- l'étape iv/ de détection de la présence d'un arc est fonction de la comparaison de la corrélation déterminée parmi ladite première, deuxième et troisième corrélations, avec un seuil ;
- l'étape iii/ de détermination de la corrélation comprend la détermination d'au moins chacune desdites première, deuxième et troisième corrélations respectives ;
- l'étape iv/ de détection de la présence d'un arc est fonction d'au moins chacune desdites première, deuxième et troisième corrélations ;

- on calcule la différence entre ladite corrélation respective déterminée parmi ladite première, deuxième et troisième corrélations pour une fenêtre et ladite corrélation respective pour une autre fenêtre, l'étape iv/ de détection de la présence d'un arc étant fonction d'au moins ladite différence calculée ;
- on calcule parmi les échantillons issus d'un filtrage respectif parmi les premier, deuxième et troisième filtrage pour la fenêtre courante, le nombre d'échantillons successifs de valeur supérieure à zéro, on compare ledit nombre à un seuil, on détecte la présence d'un arc électrique en fonction d'au moins ladite comparaison ;
- aucune desdites première, deuxième et troisième fréquences n'est égale à un entier multiple d'une autre desdites fréquences.

Suivant un deuxième aspect, la présente invention propose un programme d'ordinateur de détection d'arc électrique comportant des instructions pour mettre en oeuvre les étapes d'un procédé suivant le premier aspect de l'invention, lors d'une exécution du programme par des moyens de calcul.

Suivant un troisième aspect, la présente invention propose un dispositif de détection d'arc électrique, dans une installation électrique fournissant un signal électrique, comprenant un bloc filtreur-échantillonneur adapté pour, pendant une fenêtre temporelle d'observation du signal électrique, filtrer ledit signal en parallèle selon un premier filtrage centré sur une première fréquence selon un deuxième filtrage centré sur une deuxième fréquence et selon un troisième filtre centré sur une troisième fréquence, lesdites première, deuxième et troisième fréquences étant distinctes,
et pour déterminer, pour ladite fenêtre temporelle d'observation du signal, des échantillons de signal issu du premier filtrage, des échantillons de signal issu du deuxième filtrage et des échantillons de signal issu du troisième filtrage ;
le dispositif de détection comprenant en outre un bloc de traitement adapté pour déterminer une corrélation entre lesdits échantillons déterminés pour une fenêtre temporelle courante d'observation du signal électrique et des échantillons déterminés pour au moins une autre fenêtre temporelle d'observation du signal électrique, et pour détecter la présence d'un arc électrique en fonction d'au moins ladite corrélation déterminée ;
ledit dispositif étant caractérisé en ce que le bloc de traitement est adapté pour déterminer ladite corrélation par détermination d'au moins une corrélation respective parmi :

- une première corrélation entre lesdits échantillons de signal issu du premier filtrage déterminés pour la fenêtre courante et des échantillons de signal issu du premier filtrage déterminés pour l'autre fenêtre ;
- une deuxième corrélation entre lesdits échantillons de signal issu du deuxième filtrage déterminés pour la fenêtre courante et des échantillons de signal issu du deuxième filtrage déterminés pour l'autre fenêtre;

- une troisième corrélation entre lesdits échantillons de signal issu du troisième filtrage déterminés pour la fenêtre courante et des échantillons de signal issu du troisième filtrage déterminés pour l'autre fenêtre ; et

en ce que le bloc de traitement est adapté pour détecter la présence d'un arc en fonction d'au moins la corrélation déterminée parmi ladite première, deuxième et troisième corrélations.

Ces caractéristiques et avantages de l'invention apparaîtront à la lecture de la description qui va suivre, donnée uniquement à titre d'exemple, et faite en référence aux dessins annexés, sur lesquels :

- la figure 1 représente une installation électrique munie d'un dispositif de détection d'arc électrique dans un mode de réalisation de l'invention ;
- la figure 2 est une vue de modules fonctionnels d'un dispositif de détection d'arc électrique dans un mode de réalisation de l'invention ;
- la figure 3 est un organigramme d'un procédé de détection d'arc électrique dans un mode de réalisation de l'invention ;
- la figure 4 représente l'évolution dans le temps, pour des cycles successifs, du signal s, des échantillons en sortie du filtre $F_1$ et de la valeur d'un paramètre de corrélation correspondant ;
- la figure 5 représente l'évolution dans le temps, pour des cycles successifs, du signal s, de la corrélation des échantillons en sortie du filtre $F_1$ et de cette corrélation filtrée par un filtre passe-bas ;
- la figure 6 représente l'évolution dans le temps, pour des cycles successifs, du signal s et de différents paramètres $CorrFilt_1$, $CorrFiltAC_1$ et $CorrFiltACFilt_1$, obtenus à partir de la corrélation des échantillons en sortie du filtre $F_1$ ;
- la figure 7 représente l'évolution dans le temps, pour des cycles successifs, du signal s et de différents paramètres $CorrFilt_1$ et $DiffCorrFilt_1$ obtenus à partir de la corrélation des échantillons en sortie du filtre $F_1$ ;
- la figure 8 représente l'évolution dans le temps, pour des cycles successifs k=i, i+1 etc., du signal s, des 38 échantillons par cycle k $Ech_{1k}$, $Ech_{2k}$, $Ech_{3k}$, et des paramètres $count\_timeFilt_1$, $count\_timeFilt_2$, $count\_timeFilt_3$ calculés pour ces cycles.

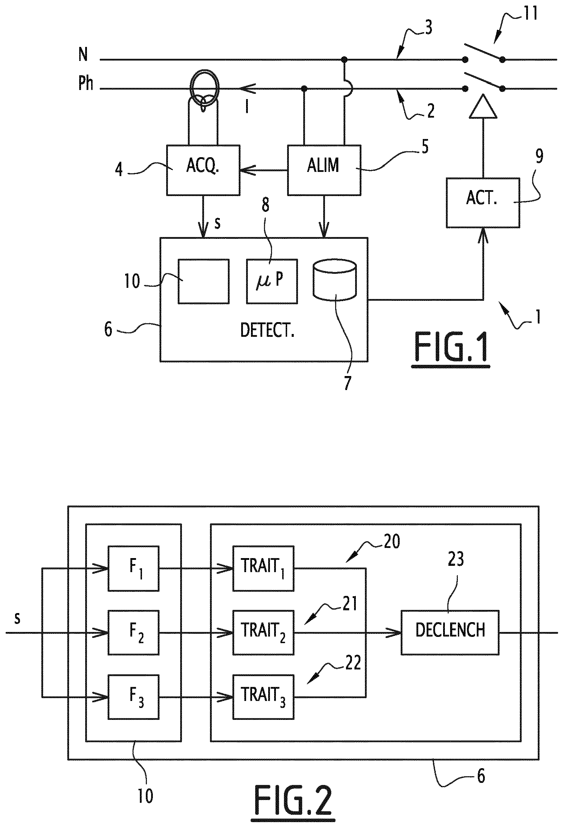

Sur la figure 1, une installation électrique 1, dans un mode de réalisation de l'invention, est représentée. Cette installation électrique comporte un conducteur de courant de phase 2 et un conducteur de courant de neutre 3. Elle comporte en outre un système d'acquisition 4, un bloc d'alimentation électrique 5, un dispositif de détection d'arc électrique 6, ci-après nommé « module de détection » et un actionneur 9.

Le système d'acquisition 4 est adapté pour acquérir des valeurs d'au moins une grandeur électrique représentative de l'installation électrique, notamment d'une valeur de courant ou de tension.

Par exemple, dans le cas considéré, le système d'acquisition 4 comprend un capteur de courant délivrant un signal s représentatif d'un courant de ligne i circulant dans l'installation électrique, par exemple d'un courant de phase, à l'aide d'un tore de mesure de courant. Dans des modes de réalisation, ce signal est représentatif de la dérivée temporelle du courant i, di/dt, ou encore de la tension électrique de l'alimentation électrique.

Ce signal électrique s est fourni en entrée du module de détection 6.

Le module de détection 6 comporte un ensemble 10 de filtres passe-bandes, un microprocesseur 8 et une base de données 7.

L'ensemble 10 de filtres passe-bandes comporte, dans le cas présent, trois filtres passe-bandes $F_1$, $F_2$ et $F_3$.

Le module de détection 6 est adapté pour effectuer des traitements à partir du signal s qui lui est fourni en entrée, de manière à détecter ou non la présence d'un arc électrique, dans l'installation électrique 1, et pour commander en fonction de ces traitements le déclenchement ou non de l'actionneur 9.

L'actionneur 9 est adapté pour, en fonction de commandes reçues du module de détection 6, interrompre, par exemple par ouverture d'interrupteurs 11 disposés sur les conducteurs 2, 3, ou permettre la circulation du courant dans l'installation électrique 1, par exemple en laissant les interrupteurs fermés.

La mémoire 7 du module de détection 6 est adaptée pour mémoriser des valeurs de divers paramètres, et des échantillons filtrés définis ci-dessous, ainsi que des instructions logicielles définissant des fonctions et étapes détaillées ci-après et mises en oeuvre par le module de détection 6 lorsque ces instructions logicielles sont exécutées par le microprocesseur 8.

En référence à la figure 2, le module de détection 6 comporte ainsi 3 chaînes de traitement 20, 21, 22 agissant en parallèle à partir du signal s, et un bloc de déclenchement 23 auquel les résultats des chaînes de traitement sont fournis.

La première chaîne de traitement 20 comporte le filtre $F_1$, suivi d'un module de traitement $TRAIT_1$.

La deuxième chaîne de traitement 21 comporte le filtre $F_2$, suivi d'un module de traitement $TRAIT_2$.

La troisième chaîne de traitement 22 comporte le filtre $F_3$, suivi d'un module de traitement $TRAIT_3$.

Chaque filtre $F_n$ est un filtre passe-bande centré sur la fréquence $f_n$, n = 1 à 3.

Par exemple, aucune de ces fréquences $f_n$ n'est un multiple entier d'une autre de ces fréquences $f_n$. Les fréquences $f_n$ sont choisies dans la plage de 10kHz-100kHz.

Dans le mode de réalisation considéré, chaque filtre $F_n$ est de type à capacité commutée. La tension V en sortie du filtre est donc le résultat à la fois d'un filtrage et d'un échantillonnage du signal s qui lui est fourni en entrée. Dans d'autres modes de réalisation, l'échantillonnage est réalisé en entrée du module de traitement.

Dans le cas considéré, chaque filtre $F_n$ est adapté pour fournir, lors d'un $i^{ème}$ cycle de détection considéré, de durée T, pour le signal s, N échantillons de la tension V, représentatifs de la composante de fréquence $f_n$ du signal s.

Dans le mode de réalisation décrit, la fréquence d'échantillonnage est de 4kHz.

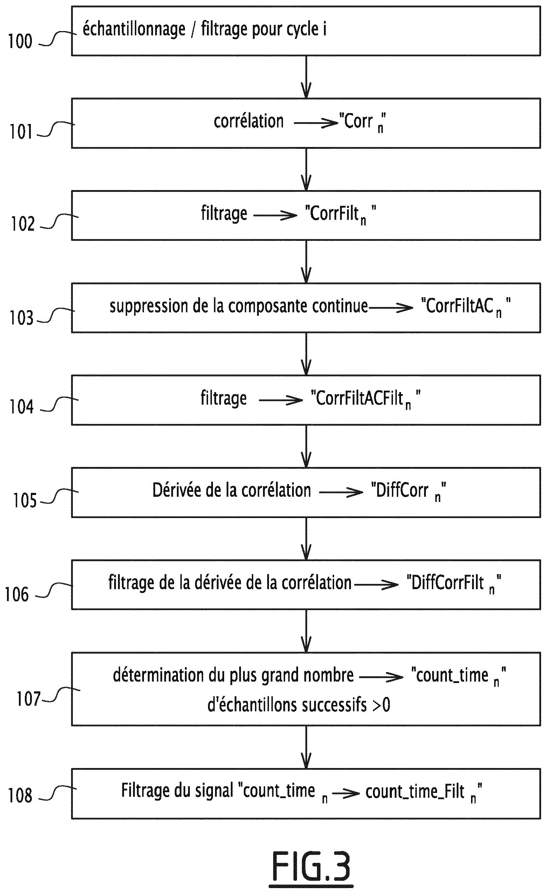

Ainsi, en référence à l'organigramme représenté en figure 3, dans le cas considéré, dans une étape 100, lors du $i^{ème}$ cycle, le filtre $F_n$ avec n = 1 à 3, délivre les échantillons $Ech_{ni}(j)$, j= 0 à 37, à la chaîne de traitement $TRAIT_n$ dont les traitements relatifs à l'identification de la présence de bruit caractéristique d'un arc vont permettre au bloc de déclenchement 23 de déterminer la présence ou non d'un arc électrique.

Le module de traitement $TRAIT_n$ est adapté pour mettre en oeuvre les étapes de traitement indiquées ci-après en référence à la figure 3, avec n = 1 à 3, de manière à obtenir les valeurs, pour le $i^{ème}$ cycle, des paramètres suivants notamment :

- $Corr_n[i]$ ;
- $CorrFilt_n[i]$ ;
- $CorrFiltAC_n[i]$ ;
- $CorrFiltACFilt_n[i]$ ;
- $DiffCorr_n[i]$ ;
- $DiffCorrFilt_n[i]$ ;
- $count\_time\_Filt_n[i]$.

Dans une étape 101, la corrélation entre des cycles distincts, par exemple le $i^{ème}$ cycle courant et le $(i-2)^{ème}$ cycle, pour la fréquence $f_n$, est calculée, de manière à détecter un comportement non périodique. Par exemple, on calcule d'abord, pour j = 0 à 37, $|Ech_{ni}(j) - Ech_{n(i-2)}(j)|$, puis on en déduit $Corr_n$ pour le cycle i :

$$Corr_n[i] = \sum_{j=0\ à\ 37} | Ech_{ni}(j) - Ech_{n(i-2)}(j) |.$$

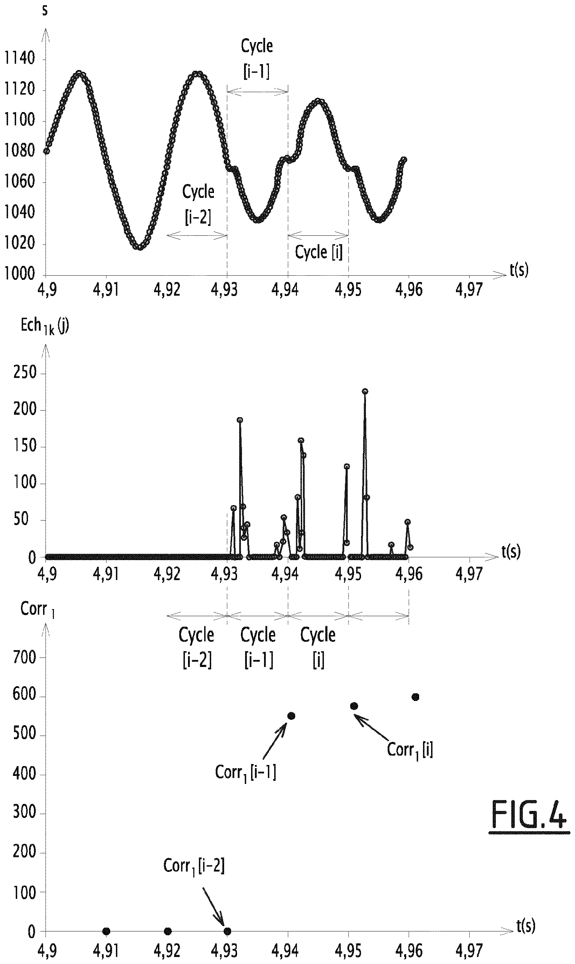

A titre d'illustration, la figure 4 représente sur le graphe supérieur, le signal s obtenu entre des cycles successifs k=i-3 à i, en fonction du temps t exprimé en seconde (s).

La figure 4 représente sur le graphe intermédiaire, les échantillons $Ech_{1k}(j)$ avec j=0 à 37, obtenus entre des cycles successifs k= i-3 à i, en fonction du temps t exprimé en seconde (s).

La figure 4 représente sur le graphe inférieur, la corrélation $Corr_1$ obtenue entre des cycles successifs i-3 à i, en fonction du temps t exprimé en seconde (s).

Dans une étape 102, afin d'assurer un comportement répétitif de la détection et de maîtriser les temps de déclenchement en ouverture de l'actionneur 9, un filtre passe-bas est appliqué à la corrélation ainsi calculée, délivrant la valeur du paramètre $CorrFilt_n[i]$ pour le cycle i.

Un filtre passe-bas est appliqué au paramètre $CorrFilt_n[i]$ ainsi calculé, délivrant la valeur du paramètre $CorrFiltFilt_n[i]$ pour le cycle i.

La fonction de transfert du filtre passe-bas est du premier ordre :

$Y(n+1) = 2^{-w}.X(n) + (1 - 2^{-w}).Y(n)$, où w est un entier positif.

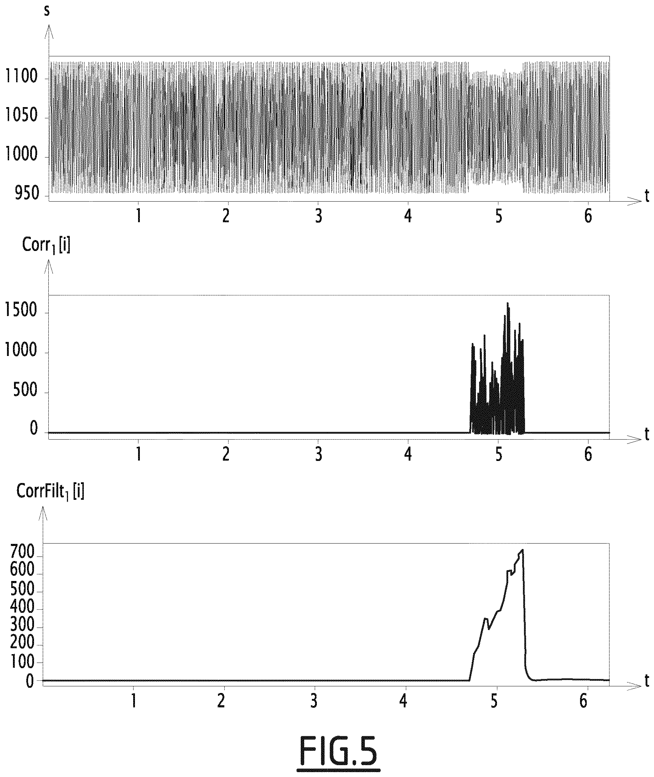

A titre d'illustration, la figure 5 représente sur le graphe supérieur, le signal s obtenu pour des cycles successifs temporels le long de l'axe du temps exprimé en seconde (s).

La figure 5 représente sur le graphe intermédiaire, les valeurs de corrélation $Corr_1$ obtenues pour des cycles successifs temporels le long de l'axe du temps exprimé en seconde (s), en référence à la fréquence basse $f_1$.

La figure 5 représente sur le graphe inférieur, la corrélation filtrée $CorrFilt_1$ obtenue en référence à la fréquence basse $f_1$, pour des cycles successifs temporels le long de l'axe du temps exprimé en seconde (s).

Dans certains cas, le résultat de la corrélation avant un arc est différent de zéro et à l'apparition de l'arc, la valeur de la corrélation s'accroît.

Dans une étape 103, afin de forcer la corrélation à zéro avant un arc (la corrélation étant différente de zéro après l'arc), on supprime cette corrélation d'avant arc, appelée composante continue, en soustrayant du paramètre $CorrFilt_n[i]$, le paramètre $CorrFiltFilt_n[i]$. Le résultat délivre le paramètre $CorrFiltAC_n$ nommé, pour le cycle i considéré : $CorrFiltAC_n[i]$.

Dans une étape 104, un filtrage supplémentaire permet de lisser le signal obtenu et d'éviter de fréquents passages par zéro, délivrant le paramètre $CorrFiltACFilt_n$, soit pour le cycle i considéré : $CorrFiltACFilt_n[i]$.

La fonction de transfert du filtre passe-bas utilisé est du premier ordre :

$Y(n+1) = 2^{-m}.X(n) + (1 - 2^{-m}).Y(n)$, avec m entier positif.

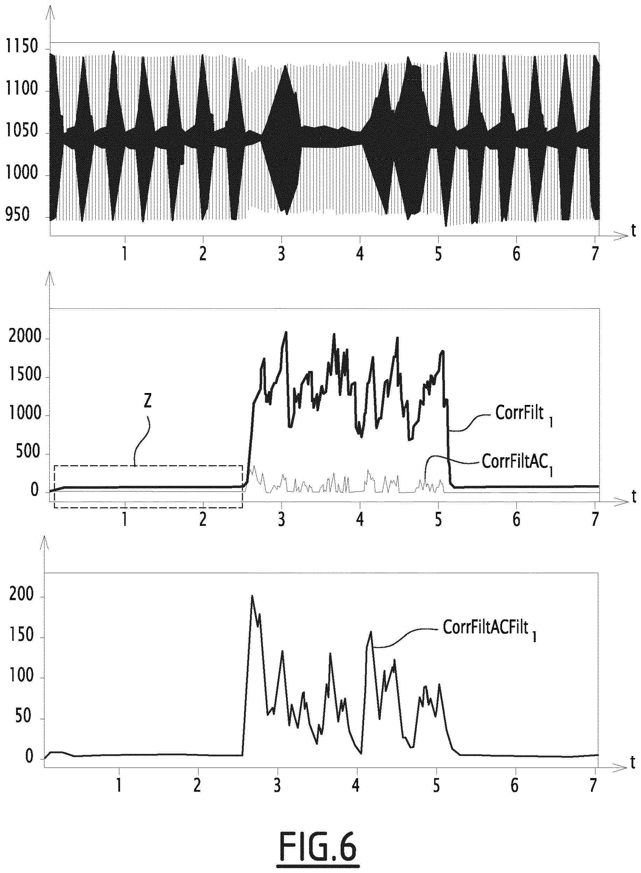

A titre d'illustration, la figure 6 représente sur le graphe supérieur, le signal s obtenu pour des cycles successifs temporels le long de l'axe du temps exprimé en seconde (s).

La figure 6 représente sur le graphe intermédiaire, les valeurs de corrélation filtrée $CorrFilt_1$ et celles obtenues après suppression de la composante continue, i.e, $CorrFiltAC_1$ obtenues pour des cycles successifs temporels le long de l'axe du temps exprimé en seconde (s), en référence à la fréquence basse $f_1$ (les valeurs de $CorrFiltAC_1$ sont bien nulles dans la zone Z).

La figure 6 représente sur le graphe inférieur, la corrélation filtrée après suppression de la composante continue, soit $CorrFiltACFilt_1$ obtenue en référence à la fréquence basse $f_1$, pour des cycles successifs temporels le long de l'axe du temps exprimé en seconde (s).

Dans une étape 105, de manière à pouvoir différentier des régimes transitoires de l'apparition d'un arc, on calcule la dérivée de la corrélation (la corrélation étant exprimée par un des paramètres de corrélation précédemment déterminé $Corr_n$, $CorrFilt_n$, $CorrFiltAC_n[i]$ ou $CorrFiltACFilt_n$), ce qui revient à appliquer un filtre passe-haut.

Ainsi on calcule $DiffCorr_n[i] = |CorrFilt_n[i] - CorrFilt_n[i-1]|$.

Ensuite, dans une étape 106, on applique un filtre passe-bas à $DiffCorr_n$ pour lisser le signal et éviter les passages fréquents par zéro. Le signal fourni en sortie de ce filtre pour le cycle i est $DiffCorrFilt_n[i]$.

La fonction de transfert du filtre passe-bas est du premier ordre :

$Y(n+1) = 2^{-t}.X(n) + (1 - 2^{-t}).Y(n)$, où t est un entier positif.

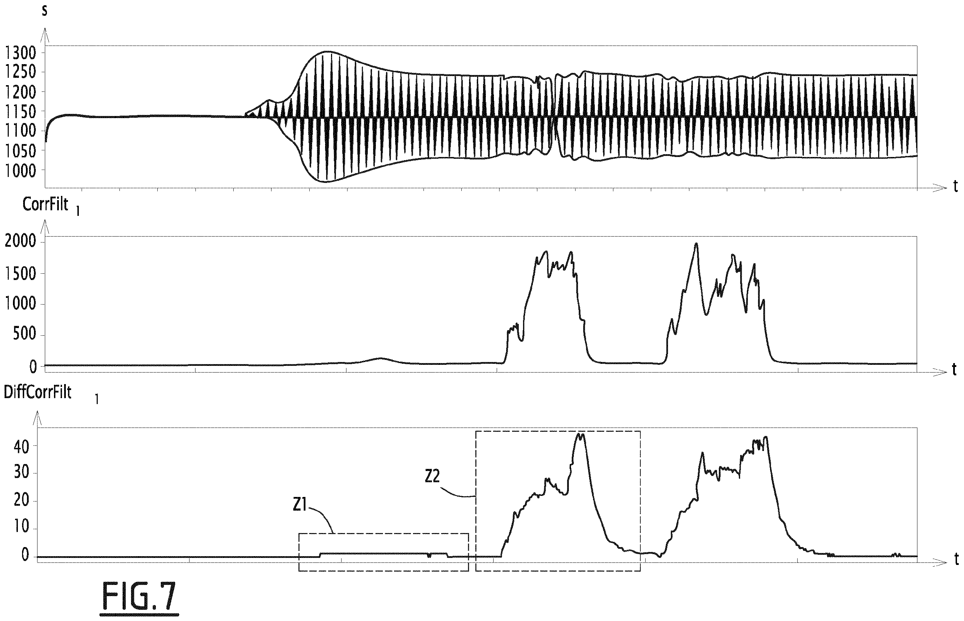

A titre d'illustration, la figure 7 représente sur le graphe supérieur, le signal s obtenu pour des cycles successifs temporels le long de l'axe du temps exprimé en seconde (s).

La figure 7 représente sur le graphe intermédiaire, les valeurs représentatives de la corrélation (dans le cas considéré, la corrélation est représentée par le paramètre $CorrFilt_1$) obtenues pour des cycles successifs temporels le long de l'axe du temps exprimé en seconde (s), en référence à la fréquence basse $f_1$.

La figure 7 représente sur le graphe inférieur, la dérivée filtrée de la corrélation $DiffCorrFilt_1$ obtenue à l'issue des étapes 105 et 106 sur la base cette fois du paramètre représentatif de la corrélation, $CorrFilt_1$ en référence à la fréquence basse $f_1$, pour des cycles successifs temporels le long de l'axe du temps exprimé en seconde (s).

On distingue ainsi sur ce graphe inférieur, la zone Z1 correspondant à des valeurs nulles ou très proches de zéro de $DiffCorrFilt_1$ qui est une zone de régime transitoire, de la zone Z2 dans laquelle les valeurs de $DiffCorrFilt_1$ sont non nulles et bien supérieures aux valeurs dans le régime transitoire, et qui est représentative de la présence d'un arc.

Par ailleurs, l'observation de la distribution des échantillons délivrés par un filtre $F_n$, n = 1 à 3 d'une part, et d'autre part du nombre de ces échantillons strictement supérieurs à zéro, permet de différencier une charge en fonctionnement normal d'un défaut d'arc.

Notamment, des passages plus fréquents par la valeur zéro des échantillons sont réalisés en présence d'un arc.

A cette fin, dans une étape 107, pour n = 1 à 3, on détermine pour le cycle courant i la valeur du paramètre $count\_time_n[i]$, qui est égal au plus grand nombre d'échantillons successifs supérieurs à zéro, pendant le cycle. Cette disposition permet de détecter la forme de la distribution des échantillons obtenus pour chaque fréquence $f_n$.

Dans une étape 108, on applique ensuite au signal $count\_time_n$ un filtre pour lisser le signal et éviter de fréquents passages par zéro.

La fonction de transfert du filtre passe-bas est du premier ordre :

$Y(n+1) = 2^{-v} \cdot X(n) + (1 - 2^{-v}) \cdot Y(n)$, où v est un entier positif

Le paramètre $count\_timeFilt_n[i]$ est délivré en sortie de ce filtre.

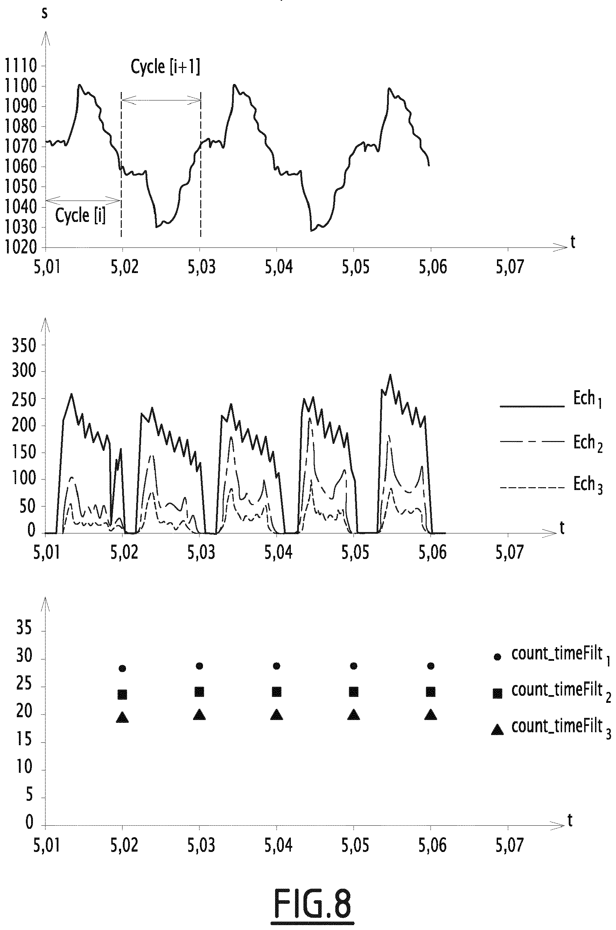

Pour illustration, la figure 8 représente sur le graphe supérieur, le signal s obtenu pour des cycles successifs temporels le long de l'axe du temps exprimé en seconde (s),.

Le graphe intermédiaire en figure 8 représente l'évolution dans le temps, pour des cycles successifs k=i, i+1 etc., du signal s, des échantillons $Ech_{1k}$ en sortie du filtre $F_1$ (en traits pleins), $Ech_{2k}$ en sortie du filtre $F_2$ (en tirets), $Ech_{3k}$ en sortie du filtre $F_3$ (en pointillés).

Le graphe inférieur en figure 8 représente l'évolution dans le temps, pour des cycles successifs k=i, i+1 etc., des paramètres $count\_timeFilt_1$ (ronds), $count\_timeFilt_2$ (carrés), $count\_timeFilt_3$ (triangles) calculés pour ces cycles..

Comme indiqué ci-dessus, le nombre d'échantillons successifs en sortie de filtre dont la valeur est distincte de zéro peut donner une information discriminatoire sur la présence d'un arc. Notamment une valeur nulle ou au contraire très élevée est généralement synonyme de l'absence d'un arc.

Dans un autre mode de réalisation, le comptage des valeurs successives différentes de zéro se fait sur la durée d'une portion de cycle, par exemple un demi-cycle, à la place de la durée d'un cycle. Ceci permet la détection au plus tôt de la présence d'un arc.

Les paramètres calculés pour le $i^{ème}$ cycle considéré pour les trois chaînes de traitement 20, 21, 22 associées respectivement aux fréquences basse, moyenne et haute $f_1$, $f_2$ et $f_3$, sont délivrés au bloc de déclenchement 23.

Le bloc de déclenchement est adapté pour détecter ou non la présence d'un arc en fonction de certains au moins de ces paramètres calculés pour au moins le cycle i, considérés indépendamment pour chaque fréquence et/ou combinés entre eux pour une fréquence donnée et/ou combinés entre eux pour plusieurs fréquences et pour envoyer une commande d'ouverture des commutateurs 11 à l'actionneur 9 quand un arc est détecté.

Dans un mode de réalisation, cette détection est réalisée en fonction de règles appliquées à ces paramètres.

Ces règles peuvent s'appliquer aux paramètres considérés indépendamment par fréquence $f_1$, $f_2$, $f_3$, ou combiner les paramètres pour une fréquence donnée et/ou combiner les paramètres pour plusieurs fréquences.

Par exemple, les règles peuvent comprendre les règles suivantes, appliquées sur un seul cycle i, ou encore combinant prenant en compte leur application sur plusieurs cycles :

- Règle 1 : si $CorrFiltACFilt_1$ > $SeuilCorr_1$ OU si $CorrFiltACFilt_2$ > $SeuilCorr_2$ OU si $CorrFiltACFilt_3$ > $SeuilCorr_3$ : la présence d'un arc est détectée (les valeurs de $SeuilCorr_n$,n = 1 à 3, sont des seuils prédéterminés) ;

- Règle 2 : si $DiffCorrFilt_1$ OU $DiffCorrFilt_2$ OU $DiffCorrFilt_3$ est non nul : la présence d'un arc est détectée.

- Règle 3 : si $count\_time\_Filt_1$ OU $count\_time\_Filt_2$ OU $count\_time\_Filt_3$ <seuil_count- : la présence d'un arc est détectée ;

- Règle 4 : si CorrFiltACFilt1 > SeuilCorr1 et si CorrFiltACFilt2 > SeuilCorr2 et si CorrFiltACFilt3 > SeuilCorr3 : la présence d'un arc est détectée (les valeurs de SeuilCorrn,n = 1 à 3, sont des seuils prédéterminés) ;

- Règle 5 : si CorrFiltACFilt1 > SeuilCorr1 Ou (si CorrFiltACFilt2 > SeuilCorr2 et si CorrFiltACFilt3 > SeuilCorr3): la présence d'un arc est détectée (les valeurs de SeuilCorrn,n = 1 à 3, sont des seuils prédéterminés) ;

- Règle 6 : si (CorrFiltACFilt1 > SeuilCorr1 et si CorrFiltACFilt2 > SeuilCorr2) Ou si CorrFiltACFilt3 > SeuilCorr3 : la présence d'un arc est détectée (les valeurs de SeuilCorrn,n = 1 à 3, sont des seuils prédéterminés) ;

- Règle 7 : (si CorrFiltACFilt1 > SeuilCorr1 et CorrFiltACFilt3 > SeuilCorr3) Ou si CorrFiltACFilt2 > SeuilCorr2 et si: la présence d'un arc est détectée (les valeurs de SeuilCorrn,n = 1 à 3, sont des seuils prédéterminés) ;

- Règle 8 : si CorrFiltACFilt1 > SeuilCorr1 et si CorrFiltACFilt2 > SeuilCorr2 et si DiffCorrFilt3 est non nul et si count_time_Filt2 <seuil_count: la présence d'un arc est détecté (les valeurs de SeuilCorrn,n = 1 à 3, sont des seuils prédéterminés) ;

Ces règles ne sont que des exemples. Un nombre infini de règles est déterminables, combinant certains des paramètres calculés ci-dessus et éventuellement d'autres critères.

Selon l'invention, la valeur de certains au moins des différents paramètres calculés relativement à chaque fréquence $f_1$, $f_2$, $f_3$, et le cas échéant de leur comparaison avec des seuils, permettent de détecter des arcs qui n'étaient pas perçus avec les techniques de l'art antérieur.

Dans le mode de réalisation considéré, l'installation électrique comportait un conducteur de courant de phase et un conducteur de courant de neutre, mais l'invention peut bien sûr être mise en oeuvre pour tout type d'installation électrique, par exemple une installation avec 3 conducteurs de phase et un conducteur de neutre.

Dans le mode de réalisation décrit, l'ensemble de filtres comportait trois filtres. Le nombre de filtres peut être 3 ou plus (on peut faire une détection d'arc avec un seul filtre, mais pour des raisons de robustesses on utilise 3, donc le nombre de filtre >=3 risque de limiter la couverture du brevet), de même que le nombre de chaînes de traitement opérant en parallèle sur le signal en amont du bloc de déclenchement 23.

Dans le mode de réalisation, les filtres passe-bandes sont à capacité commuté et effectuent à la fois un filtrage et un échantillonnage. Dans d'autres modes de réalisation, le filtrage et l'échantillonnage peuvent être réalisés de façon séparée.

Dans des modes de réalisation, seules certaines des étapes décrites ci-dessus sont mises en oeuvre. Il n'est pas nécessaire que tous les paramètres indiqués soient calculés et d'autres paramètres peuvent être pris en compte pour la détection.

## Revendications

1. Procédé de détection d'arc électrique dans une installation électrique (1) fournissant un signal électrique, comprenant les étapes suivantes réalisées relativement à une fenêtre courante d'une pluralité de fenêtres temporelles d'observation du signal électrique :

   i/ application audit signal électrique en parallèle d'au moins un premier filtrage centré sur une première fréquence ($F_1$), d'un deuxième filtrage centré sur une deuxième fréquence ($F_2$) et d'un troisième filtrage centré sur une troisième fréquence ($F_3$), lesdites première, deuxième et troisième fréquences étant distinctes ;
   ii/ détermination, pour ladite fenêtre, d'au moins d'échantillons issus du premier filtrage, d'échantillons issus du deuxième filtrage et d'échantillons issus du troisième filtrage ;
   iii/ détermination de la corrélation entre lesdits échantillons déterminés pour la fenêtre courante et des échantillons déterminés suite à la mise en oeuvre des étapes i/ et /ii pour au moins une autre fenêtre de la pluralité de fenêtres temporelles d'observation du signal électrique ; et
   iv/ détection de la présence d'un arc électrique en fonction d'au moins ladite corrélation déterminée ;

   l'étape iii/ de détermination de la corrélation comprenant la détermination d'au moins une corrélation respective parmi :

   - une première corrélation entre lesdits échantillons issus du premier filtrage et déterminés pour la fenêtre courante et des échantillons issus du premier filtrage et déterminés pour l'autre fenêtre ;
   - une deuxième corrélation entre lesdits échantillons issus du deuxième filtrage et déterminés pour la fenêtre courante et des échantillons issus du deuxième filtrage et déterminés pour l'autre fenêtre;
   - une troisième corrélation entre lesdits échantillons issus du troisième filtrage et déterminés pour la fenêtre courante et des échantillons issus du troisième filtrage et déterminés pour l'autre fenêtre ;

   ledit procédé étant **caractérisé en ce qu'**il contient, en outre, une étape v/ de calcul, parmi les échantillons issus d'un filtrage respectif parmi les premier, deuxième et troisième filtrage pour la fenêtre courante, du nombre d'échantillons successifs de valeur supérieure à zéro et une étape vi/ de comparaison dudit nombre à un seuil ; et
   **en ce que** l'étape iv/ de détection de la présence d'un arc est fonction au moins de ladite comparaison et de la corrélation déterminée parmi ladite première, deuxième et troisième corrélations.

2. Procédé selon la revendication 1, selon l'étape iv/ de détection de la présence d'un arc est fonction de la comparaison de la corrélation déterminée parmi ladite première, deuxième et troisième corrélations, avec un seuil.

3. Procédé selon la revendication 1 ou 2, selon lequel l'étape iii/ de détermination de la corrélation comprend la détermination d'au moins chacune desdites première, deuxième et troisième corrélations respectives.

4. Procédé selon la revendication 3, selon lequel l'étape iv/ de détection de la présence d'un arc est fonction d'au moins chacune desdites première, deuxième et troisième corrélations.

5. Procédé selon l'une quelconque des revendications précédentes, selon lequel on calcule la différence entre ladite corrélation respective déterminée parmi ladite première, deuxième et troisième corrélations pour une fenêtre et ladite corrélation respective pour une autre fenêtre, l'étape iv/ de détection de la présence d'un arc étant fonction d'au moins ladite différence calculée.

6. Procédé selon l'une quelconque des revendications précédentes, selon lequel aucune desdites première, deuxième et troisième fréquences n'est égale à un entier multiple d'une autre desdites fréquences.

7. Programme d'ordinateur de détection d'arc électrique comportant des instructions pour mettre en oeuvre les étapes d'un procédé selon l'une quelconque des revendications précédentes, lors d'une exécution du programme par des moyens de calcul (8).

8. Dispositif de détection d'arc électrique (6), dans une installation électrique (1) fournissant un signal électrique, comprenant un bloc filtreur-échantillonneur (10) adapté pour, pendant une fenêtre temporelle d'observation du signal électrique, filtrer ledit signal en parallèle selon un premier filtrage centré sur une première fréquence (F$_1$), selon un deuxième filtrage centré sur une deuxième fréquence (F$_2$) et selon un troisième filtre centré sur une troisième fréquence (F$_3$), lesdites première, deuxième et troisième fréquences étant distinctes,

et pour déterminer, pour ladite fenêtre temporelle d'observation du signal, des échantillons de signal issu du premier filtrage, des échantillons de signal issu du deuxième filtrage et des échantillons de signal issu du troisième filtrage ;

le dispositif de détection comprenant en outre un bloc de traitement (8, 7) adapté pour déterminer une corrélation entre lesdits échantillons déterminés pour une fenêtre temporelle courante d'observation du signal électrique et des échantillons déterminés pour au moins une autre fenêtre temporelle d'observation du signal électrique, et pour détecter la présence d'un arc électrique en fonction d'au moins ladite corrélation déterminée ;

le bloc de traitement étant adapté pour déterminer ladite corrélation par détermination d'au moins une corrélation respective parmi :

    - une première corrélation entre lesdits échantillons de signal issu du premier filtrage déterminés pour la fenêtre courante et des échantillons de signal issu du premier filtrage déterminés pour l'autre fenêtre ;

    - une deuxième corrélation entre lesdits échantillons de signal issu du deuxième filtrage déterminés pour la fenêtre courante et des échantillons de signal issu du deuxième filtrage déterminés pour l'autre fenêtre;

    - une troisième corrélation entre lesdits échantillons de signal issu du troisième filtrage déterminés pour la fenêtre courante et des échantillons de signal issu du troisième filtrage déterminés pour l'autre fenêtre ;

ledit dispositif étant **caractérisé en ce que** le bloc de traitement est adapté pour calculer parmi les échantillons issus d'un filtrage respectif parmi les premier, deuxième et troisième filtrages pour la fenêtre courante, le nombre d'échantillons successifs de valeur supérieure à zéro, pour comparer ledit nombre à un seuil ; et

**en ce que** le bloc de traitement est adapté pour détecter la présence d'un arc en fonction au moins de ladite comparaison et de la corrélation déterminée parmi ladite première, deuxième et troisième corrélations.

9. Dispositif de détection d'arc électrique (6) selon la revendication 8, dans lequel le bloc de traitement est adapté pour détecter la présence d'un arc en fonction de la comparaison de la corrélation déterminée parmi ladite première, deuxième et troisième corrélations, avec un seuil.

10. Dispositif de détection d'arc électrique (6) selon la revendication 8 ou 9, dans lequel la détermination de la corrélation par le bloc de traitement comprend la détermination d'au moins chacune desdites première, deuxième et troisième corrélations respectives.

11. Dispositif de détection d'arc électrique (6) selon la revendication 10, dans lequel la détection de la présence d'un arc par le bloc de traitement est fonction d'au moins chacune desdites première, deuxième et troisième corrélations.

12. Dispositif de détection d'arc électrique (6) selon l'une quelconque des revendications 8 à 11, dans lequel le bloc de traitement est adapté pour calculer la différence entre ladite corrélation respective déterminée parmi ladite première, deuxième et troisième corrélations pour une fenêtre et ladite corrélation respective pour une autre fenêtre, et pour détecter la présence d'un arc étant fonction d'au moins ladite différence calculée.

13. Dispositif de détection d'arc électrique (6) selon l'une quelconque des revendications 8 à 12, selon lequel aucune desdites première, deuxième et troisième fréquences n'est égale à un entier multiple d'une autre desdites fréquences.

**Patentansprüche**

1. Verfahren zum Detektieren eines Lichtbogens in einer ein elektrisches Signal liefernden elektrischen Anlage (1), folgende Schritte umfassend, die in Bezug auf ein aktuelles Fenster aus einer Mehrzahl von Beobachtungszeitfenstern des elektrischen Signals durchgeführt werden:

    i/ Ausführen mindestens einer ersten, auf eine erste Frequenz (F$_1$) zentrierte Filterung, einer auf eine zweite Frequenz (F$_2$) zentrierte Filterung und einer dritten, auf eine dritte Frequenz (F$_3$) zentrierte Filterung des elektrischen Signals in paralleler Weise, wobei die erste, zweite und dritte Frequenz unterschiedlich zueinander sind;

    ii/ Ermitteln mindestens einer Abtastung, die von der ersten Filterung herrührt, von Abtastungen, die von der zweiten Filterung herrühren, und von Abtastungen, die von der dritten Filterung herrühren, für das Fenster;

    iii/ Bestimmen der Korrelation zwischen den für das aktuelle Fenster ermittelten Abtastungen und den Abtastungen, die infolge des Ausführens der Schritte i/ und ii/ für mindestens ein anderes Fenster der Mehrzahl von Beobachtungszeitfenstern des elektrischen Signals bestimmt wurden; und

iv/ Detektieren des Auftretens eines Lichtbogens abhängig von mindestens der bestimmten Korrelation;

wobei der Schritt iii/ des Bestimmens der Korrelation das Bestimmen mindestens einer jeweiligen Korrelation aus:

- einer ersten Korrelation zwischen den von der ersten Filterung herrührenden und für das aktuelle Fenster ermittelten Abtastungen und den von der ersten Filterung herrührenden und für das andere Fenster bestimmten Abtastungen;
- einer zweiten Korrelation zwischen den von der zweiten Filterung herrührenden und für das aktuelle Fenster ermittelten Abtastungen und den von der zweiten Filterung herrührenden und für das andere Fenster ermittelten Abtastungen;
- einer dritten Korrelation zwischen den von der dritten Filterung herrührenden und für das aktuelle Fenster ermittelten Abtastungen und den von der dritten Filterung herrührenden und für das andere Fenster ermittelten Abtastungen;

wobei das Verfahren **dadurch gekennzeichnet ist, dass** es außerdem einen Schritt v/ des Berechnens der Anzahl von aufeinanderfolgenden Abtastungen mit einem Wert größer als Null unter den von einer jeweiligen Filterung herrührenden Abtastungen der ersten, zweiten und dritten Filterung für das aktuelle Fenster und einen Schritt vi/ des Vergleichs der Anzahl mit einem Schwellenwert enthält; und dass der Schritt iv/ des Abtastens des Auftretens eines Bogens abhängig von mindestens dem Vergleich und der Korrelation, die aus der ersten, zweiten und dritten Korrelation bestimmt wurde.

2. Verfahren nach Anspruch 1, nach dem der Schritt iv/ des Detektierens des Auftretens eines Bogens abhängig ist von dem Vergleich der Korrelation, die aus der ersten, zweiten und dritten Korrelation bestimmt wird, mit einem Schwellenwert.

3. Verfahren nach Anspruch 1 oder 2, nach dem der Schritt iii/ des Bestimmens der Korrelation das Bestimmen von mindestens jeder der jeweiligen ersten, zweiten und dritten Korrelation umfasst.

4. Verfahren nach Anspruch 3, nach dem der Schritt iv/ des Detektierens des Auftretens eines Bogens abhängig von mindestens jeder der ersten, zweiten und dritten Korrelation ist.

5. Verfahren nach einem beliebigen der vorhergehenden Ansprüche, nach dem die Differenz zwischen der jeweiligen Korrelation, die aus der ersten, zweiten und dritten Korrelation für ein Fenster bestimmt wird, und der jeweiligen Korrelation für ein anderes Fenster berechnet wird, wobei der Schritt iv/ des Detektierens des Auftretens eines Bogens abhängig von mindestens der berechneten Differenz ist.

6. Verfahren nach einem beliebigen der vorhergehenden Ansprüche, nach dem keine der ersten, zweiten und dritten Frequenz gleich einem ganzzahligen Vielfachen einer anderen der Frequenzen ist.

7. Computerprogramm zum Detektieren eines Lichtbogens, das Instruktionen zum Durchführen der Schritte eines Verfahrens nach einem beliebigen der vorhergehenden Ansprüche bei der Ausführung des Programms durch Berechnungsmittel (8) aufweist.

8. Vorrichtung (6) zum Detektieren eines Lichtbogens in einer ein elektrisches Signal liefernden elektrischen Anlage (1) umfassend einen Filter-Abtastblock (10), der ausgebildet ist, parallel in einem Beobachtungszeitfenster des elektrischen Signals das Signal gemäß einer ersten, auf eine erste Frequenz ($F_1$) zentrierte Filterung, gemäß einer zweiten, auf eine zweite Frequenz ($F_2$) zentrierte Filterung, und gemäß einer dritten, auf eine dritte Frequenz ($F_3$) zentrierte Filterung zu filtern, wobei die erste, zweite und dritte Frequenz unterschiedlich zueinander sind, und für das Beobachtungszeitfenster des Signals Abtastungen des von der ersten Filterung herrührenden Signals, Abtastungen des von der zweiten Filterung herrührenden Signals und Abtastungen des von der dritten Filterung herrührenden Signals zu ermitteln;
wobei die Vorrichtung zum Detektieren außerdem einen Verarbeitungsblock (8, 7) umfasst, der ausgebildet ist, eine Korrelation zwischen den für ein aktuelles Beobachtungszeitfenster des elektrischen Signals ermittelten Abtastungen und den für mindestens ein anderes Beobachtungszeitfenster des elektrischen Signals ermittelten Abtastungen zu bestimmen und das Auftreten eines Lichtbogens abhängig von mindestens der bestimmten Korrelation zu detektieren;
wobei der Verarbeitungsblock ausgebildet ist, die Korrelation durch Bestimmen mindestens einer jeweiligen Korrelation zu bestimmen aus:

- einer ersten Korrelation zwischen den Abtastungen des von der ersten Filterung herrührenden Signals, die für das aktuelle Fenster ermittelt werden, und den Abtastungen des von der ersten Filterung herrührenden Signals, die für das andere Fenster ermittelt werden;
- einer zweiten Korrelation zwischen den Abtastungen des von der zweiten Filterung herrührenden Signals, die für das aktuelle Fenster ermittelt werden, und den Abtastungen des von der zweiten Filterung herrührenden Signals, die für das andere Fenster ermittelt werden;
- einer dritten Korrelation zwischen den Abtastungen des von der dritten Filterung herrührenden Signals, die für das aktuelle Fenster ermittelt werden, und den Abtastungen des von der dritten Filterung herrührenden Signals, die für das andere Fenster ermittelt werden;

wobei die Vorrichtung **dadurch gekennzeichnet ist, dass** der Verarbeitungsblock ausgebildet ist, aus den Abtastungen, die von der jeweiligen Filterung aus der ersten, zweiten und dritten Filterung für das aktuelle Fenster herrühren die Anzahl von aufeinanderfolgenden Abtastungen mit einem Wert größer Null zu berechnen und die Anzahl mit einem Schwellenwert zu vergleichen; und dass der Verarbeitungsblock ausgebildet ist, das Auftreten eines Bogens abhängig von mindestens dem Vergleich und der aus der ersten, zweiten und dritten Korrelation bestimmten Korrelation zu detektieren.

9. Vorrichtung zum Detektieren eines Lichtbogens (6) nach Anspruch 8, bei der der Verarbeitungsblock ausgebildet ist, das Auftreten eines Bogens abhängig von dem Vergleich der aus der ersten, zweiten und dritten Korrelation bestimmten Korrelation mit einem Schwellenwert zu detektieren.

10. Vorrichtung (6) zum Detektieren eines Lichtbogens nach Anspruch 8 oder 9, bei der das Bestimmen der Korrelation durch den Verarbeitungsblock das Bestimmen mindestens jeder der jeweiligen ersten, zweiten und dritten Korrelation umfasst.

11. Vorrichtung (6) zum Detektieren eines Lichtbogens nach Anspruch 10, bei dem das Detektieren des Auftretens eines Bogens durch den Verarbeitungsblock abhängig von mindestens jeder der ersten, zweiten und dritten Korrelation ist.

12. Vorrichtung (6) zum Detektieren eines Lichtbogens nach einem beliebigen der Ansprüche 8 bis 11, bei der der Verarbeitungsblock ausgebildet ist, die Differenz zwischen der jeweiligen Korrelation, die aus der ersten, zweiten und dritten Korrelation für ein Fenster bestimmt wird, und der jeweiligen Korrelation für ein anderes Fenster zu berechnen und das Auftreten eines Bogens abhängig von mindestens der berechneten Differenz zu detektieren.

13. Vorrichtung (6) zum Detektieren eines Lichtbogens nach einem beliebigen der Ansprüche 8 bis 12, bei der keine der ersten, zweiten und dritten Frequenz gleich einem ganzzahligen Vielfachen einer anderen der Frequenzen ist.

**Claims**

1. An electric arc detection method in an electrical installation (1) providing an electrical signal, comprising the following steps respectively carried out in a current window of a plurality of time windows for observing the electrical signal:

   i/ applying, to said electrical signal in parallel with at least one first filtering centered on a first frequency ($F_1$), a second filtering centered on a second frequency ($F_2$) and a third filtering centered on a third frequency ($F_3$), said first, second and third frequencies being distinct;
   ii/ determining, for said window, at least samples resulting from the first filtering, samples resulting from the second filtering and samples resulting from the third filtering;
   iii/ determining the correlation between said samples determined for the current window and samples determined following the implementation of steps i/ and ii/ for at least one other window from the plurality of time windows for observing the electric signal; and
   iv/ detecting the presence of an electric arc as a function of at least said determined correlation.

   step iii/ for determining the correlation comprising determining at least one respective correlation from among:

   - a first correlation between said samples resulting from the first filtering and determined for the current window and samples resulting from the first filtering and determined for the other window;
   - a second correlation between said samples resulting from the second filtering and determined for the current window and samples resulting from the second filtering and determined for the other window;
   - a third correlation between said samples resulting from the third filtering and determined for the current window and samples resulting from the third filtering and determined for the other window;

   said method being **characterized in that** it further comprises a step v/ for calculating, among the samples resulting from a respective filtering among the first, second and third filterings, for the current window, the number of successive samples with a value greater than zero and a step vi/ for comparing said number to a threshold; and
   **in that** step iv/ for detecting the presence of an arc depends on at least said comparison and the correlation determined from among said first, second and third correlations.

2. The method according to claim 1, wherein step iv/ for detecting the presence of an arc depends on the comparison of the determined correlation from among said first, second and third correlations, with a threshold.

3. The method according to claim 1 or 2, wherein step iii/ for determining the correlation comprises determining at least each of said first, second and third respective correlations.

4. The method according to claim 3, wherein step iv/ for detecting the presence of an arc depends on at least each of said first, second and third correlations.

5. The method according to any one of the preceding claims, wherein the difference between said respective correlation determined among said first, second and third correlations for one window and said respective correlation for another window is calculated, step iv/ for detecting the presence of an arc depending on at least said calculated difference.

6. The method according to any one of the preceding claims, wherein none of said first, second and third frequencies are equal to an integer that is a multiple of another of said frequencies.

7. A computer program for detecting an electric arc including instructions for implementing the steps of a method according to any one of the preceding claims, when the program is run by computation means (8).

8. A device for detecting an electric arc (6), in an electrical installation (1) providing an electrical signal, comprising a filtering-sampling unit (10) suitable, during a time window for observing the electric signal, for filtering said signal in parallel according to a first filtering centered on a first frequency ($F_1$), according to a second filtering centered on a second frequency ($F_2$), and according to a third filtering centered on a third frequency ($F_3$), said first, second and third frequencies being distinct, and for determining, for said time window for observing the signal, signal samples resulting from the first filtering, signal samples resulting from the second filtering and signal samples resulting from the third filtering;

the detection device further comprising a processing unit (8, 7) suitable for determining a correlation between said samples determined for a current time window for observing the electrical signal and samples determined for at least one other time window for observing the electrical signal, and for detecting the presence of an electric arc as a function of at least said determined correlation;

the processing unit being suitable for determining said correlation by determining at least one respective correlation from among:

- a first correlation between said signal samples resulting from the first filtering determined for the current window and signal samples resulting from the first filtering determined for the other window;
- a second correlation between said signal samples resulting from the second filtering determined for the current window and signal samples resulting from the second filtering determined for the other window;
- a third correlation between said signal samples resulting from the third filtering determined for the current window and signal samples resulting from the third filtering determined for the other window;

said device being **characterized in that** the processing unit is suitable for calculating the number of successive samples with a value greater than zero among the samples resulting from a respective filtering among the first, second and third filterings, for the current window, for comparing said number to a threshold; and

**in that** the processing unit is suitable for detecting the presence of an arc as a function of at least said comparison and the correlation determined from among said first, second and third correlations.

9. The electric arc detecting device (6) according to claim 8, wherein the processing unit is suitable for detecting the presence of an arc depends on the comparison of the determined correlation from among said first, second and third correlations, with a threshold.

10. The electric arc detecting device (6) according to claim 8 or 9, wherein the determination of the correlation by the processing unit comprises determining at least each of said first, second and third respective correlations.

11. The electric arc detecting device (6) according to claim 10, wherein the determination of the correlation by the processing unit comprises determining at least each of said first, second and third respective correlations.

12. The electric arc detecting device (6) according to any one of claims 8 to 11, wherein the processing unit is suitable for calculating the difference between said respective correlation determined among said first, second and third correlations for one window and said respective correlation for another window, and for detecting the presence of an arc depending on at least said calculated difference.

13. The electric arc detecting device (6) according to any one of claims 8 to 12, wherein none of said first, second and third frequencies are equal to an integer that is a multiple of another of said frequencies.

N

Ph

4 — ACQ.

ALIM — 5

9

ACT.

3

2

11

s

8

10

μP

6

DETECT.

7

1

## FIG.1

s

F₁

F₂

F₃

TRAIT₁

TRAIT₂

TRAIT₃

20

21

22

23

DECLENCH

10

6

## FIG.2

100 — échantillonnage / filtrage pour cycle i

↓

101 — corrélation ——→ "$Corr_n$"

↓

102 — filtrage ——→ "$CorrFilt_n$"

↓

103 — suppression de la composante continue ——→ "$CorrFiltAC_n$"

↓

104 — filtrage ——→ "$CorrFiltACFilt_n$"

↓

105 — Dérivée de la corrélation ——→ "$DiffCorr_n$"

↓

106 — filtrage de la dérivée de la corrélation ——→ "$DiffCorrFilt_n$"

↓

107 — détermination du plus grand nombre ——→ "$count\_time_n$"
d'échantillons successifs >0

↓

108 — Filtrage du signal "$count\_time_n$ ——→ $count\_time\_Filt_n$"

## FIG.3

FIG.4

FIG.5

## FIG.6

**FIG.7**

EP 2 816 363 B1

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7345860 B
- US 5602709 A
- US 5561605 A
- US 2003227290 A1